# EUROPÄISCHE PATENTANMELDUNG

(11) **EP 2 182 557 A2**
(43) Veröffentlichungstag der Anmeldung: **05.05.2010**
(21) Anmeldenummer: 09171917.9
(22) Anmeldetag: 01.10.2009
(51) Int. Cl.: H01L 33/48, H01L 25/16

(54) **LED-Leuchtmodul mit Siliziumsubstrat**

(30) Priorität: 31.10.2008 DE 102008043345
(71) Anmelder: Robert Bosch GmbH, 70442 Stuttgart (DE)
(72) Erfinder: Richter, Josef, 72770, Reutlingen (DE); Weber, Heribert, 72622, Nuertingen (DE); Farber, Paul, 70193, Stuttgart (DE); Kalich, Thomas, 72805, Lichtenstein (DE)

(57) **Zusammenfassung**

Die Erfindung betrifft ein Leuchtmodul (1) mit einem Substrat (2) und mindestens einer Leuchtdiode (3), wobei das Substrat (2) ein Siliziumsubstrat und die Leuchtdiode (3) ein Leuchtdioden-Chip (4) ist. Dabei ist vorgesehen, dass das Substrat (2) eine Kavität (5) aufweist, in der eine weitere Kavität (6) ausgebildet ist, und dass der Leuchtdioden-Chip (4) in der weiteren Kavität (6) angeordnet ist.

## Beschreibung

Die Erfindung betrifft ein Leuchtmodul mit einem Substrat und mindestens einer Leuchtdiode, wobei das Substrat ein Siliziumsubstrat und die Leuchtdiode ein Leuchtdioden-Chip ist.

### Stand der Technik

Eine der höchsten Hürden zur breiten Verwendung von effizientem und energiesparendem LED-Licht liegt darin, dass die Lichtausbeute der heutigen LED-Aufbauten nicht effizient genug ist. Deswegen verwendet man, um einen höheren Lichtfluss zu bekommen, mehrere LED-Chips, also Leuchtdioden-Chips, die zu einem Leuchtmodul zusammengeschaltet werden. Aus dem Stand der Technik sind Leuchtmodule mit mehreren Leuchtdioden-Chips bekannt, wobei die Leuchtdioden-Chips auf einem Substrat aufgebracht und einzeln mit einem Konvertierungsmittel, beispielsweise Phosphor, beschichtet werden. In abbildenden Optiken, wie beispielsweise einem Scheinwerfer, werden zwischen den hellen Leuchtdioden-Chips liegende Dunkelräume ebenso abgebildet wie die hellen Leuchtdioden-Chips und müssen optisch über geeignete Strahlengänge überbrückt werden, um ein gutes Leuchtergebnis zu erzielen. Aus dem Stand der Technik, beispielsweise der DE 10 2006 040 641 A1, sind Leuchtmodule mit mindestens einer auf einem Substrat angeordneten Leuchtdiode bekannt, wobei das Substrat als Siliziumsubstrat und die Leuchtdiode als Leuchtdioden-Chip ausgebildet ist. Dabei soll sich zwischen dem Siliziumsubstrat und dem Leuchtdioden-Chip eine Siliziumoxid-Schicht befinden. Diese wirkt als elektrisch isolierende Schicht zwischen dem Siliziumsubstrat und dem Leuchtdioden-Chip. Aus der genannten Offenlegungsschrift ist ebenso bekannt, dass der Leuchtdioden-Chip in einer Kavität angeordnet sein kann und die Kavität nach dem Anordnen des Leuchtdioden-Chips mit dem Konvertierungsmittel aufgefüllt wird. Bei diesem Aufbau ist es vorgesehen, dass ein Bonddraht zur elektrischen Anbindung des Leuchtdioden-Chips zu einer Montageebene über eine Kante des Leuchtdioden-Chips geführt wird. Dabei muss der Bonddraht bei einem Bondvorgang so geführt werden, dass es zu keinem ungewollten Kontakt mit dem Leuchtdioden-Chip kommen kann. Dies reduziert jedoch die Taktzeit beim Bonden und führt somit zur Erhöhung der Fertigungskosten. Auch kann bei diesem Konzept die Lage des Leuchtdioden-Chips nicht gut definiert werden, da Leuchtdioden-Chips während eines Aufbauprozesses, beispielsweise Löten, unkontrolliert wandern können.

### Offenbarung der Erfindung

Demgegenüber weist das Leuchtmodul mit den in Anspruch 1 genannten Merkmalen den Vorteil auf, das die Leuchtmodule mit hoher Taktzeit gebondet und zudem der Bonddraht zwischen Leuchtdioden zwischen Leuchtdioden-Chip und einer Kontaktstelle zum Anschluss des Leuchtdioden-Chips sehr flach gehalten werden kann. Dies wird erfindungsgemäß erreicht, indem das Substrat eine Kavität aufweist, in der eine weitere Kavität ausgebildet ist, und dass der Leuchtdioden-Chip in der weiteren Kavität angeordnet ist. Durch die Anordnung des Leuchtdioden-Chips in der weiteren Kavität kann dieser während dem Aufbauprozess in einer definierten Position gehalten werden, da wegen den durch die weitere Kavität gebildeten, insbesondere umlaufenden, Begrenzungen kein unkontrolliertes Wandern auftreten kann. Somit kann mit hoher Taktzeit gebondet werden, was die Fertigungskosten reduziert. Außerdem können die Bonddrähte zwischen Leuchtdioden-Chip und der Kontaktstelle sehr flach gehalten werden. Dies ist wichtig, um den höchsten Punkt der Bonddrähte sicher unter einer Oberkante der Kavität halten zu können. Wird die Kavität mit dem Konvertierungsstoff aufgefüllt, so werden alle Bonddrahtverbindungen innerhalb der Kavität umschlossen. Damit sind sie sicher gehalten und beeinflussen nicht eine Verteilung des austretenden Lichts. Es ist selbstverständlich auch möglich, dass das Substrat beziehungsweise das Leuchtmodul mehrere Kavitäten aufweist. Ebenso sind pro Kavität mehrere weitere Kavitäten möglich. Es kann auch vorgesehen sein, dass mehrere Leuchtdioden-Chips in der weiteren Kavität angeordnet werden. Der Leuchtdioden-Chip ist, da er in der weiteren Kavität vorgesehen ist, in der tiefsten Lage der Kavität angeordnet. Dabei ist es vorteilhaft, wenn die Dicke des unter dem Leuchtdioden-Chip verbliebenen Substrats (nach einem Ausbilden der Kavität und der weiteren Kavität) im Vergleich zu der Dicke des Substrats ohne Kavität sehr dünn ist. Auf diese Weise kann die von dem Leuchtdioden-Chip erzeugte Wärme sehr gut abgeführt werden. So ist neben den weiteren Vorteilen auch eine gute Kühlung des Leuchtdioden-Chips gewährleistet.

Eine Weiterbildung der Erfindung sieht vor, dass die weitere Kavität in der Kavität mindestens eine Terrasse ausbildet. Eine Grundfläche der weiteren Kavität ist also kleiner als eine Grundfläche der Kavität. Somit bilden sich beim Erzeugen der weiteren Kavität in der Kavität neben der Grundfläche der weiteren Kavität Terrassen beziehungsweise mindestens eine Terrasse aus. Diese Terrasse kann zur Stabilisierung beziehungsweise zur Befestigung des Konvertierungsstoffes und/oder zur Ausbildung einer Kontaktstelle zum elektrischen Kontaktieren des Leuchtdioden-Chips genutzt werden.

Eine Weiterbildung der Erfindung sieht vor, dass auf dem Substrat eine Passivierschicht, insbesondere aus SiO₂, aufgebracht ist. Die Passivierschicht ist dabei vorzugsweise auf der gesamten Oberfläche des Substrats aufgebracht, auch in der Kavität und/oder der weiteren Kavität. Die Passivierschicht kann als Siliziumoxid- Schicht, bevorzugt als Siliziumdioxid-Schicht, ausgebildet sein. Sie bildet eine elektrisch isolierende Schicht zwischen dem Siliziumsubstrat und dem Leuchtdioden-Chip. Die Passivierschicht begünstigt vorteilhafterweise die Wärmeabfuhr von dem Leuchtdioden-Chip. Dies ist gegeben, wenn die Siliziumoxid-Schicht oder Siliziumdioxid-Schicht verwendet wird. Diese weist zum einen im Vergleich zu physikalisch aufgebrachten Isolierschichten eine sehr geringe Höhe auf und zum anderen hat sie eine moderate Wärmeleitfähigkeit, so dass die von dem Leuchtdioden-Chip erzeugte Wärme abgeführt werden kann.

Eine Weiterbildung der Erfindung sieht vor, dass auch der Passivierschicht eine metallische Schicht, insbesondere aus TiW oder Au bestehend oder dieses aufweisend vorgesehen ist. Die metallische Schicht ist vorzugsweise elektrisch leitfähig. Sie kann strukturiert sein, das heißt elektrisch leitfähige Leiterbahnen ausbilden. Besonders vorteilhaft ist die metallische Schicht aus einer Titan-Wolfram-Legierung oder Gold hergestellt oder weist dieses zumindest auf. Die metallische Schicht ist auf der Passivierschicht angeordnet, so dass die Passivierschicht die metallische Schicht von dem Siliziumsubstrat isoliert. Die metallische Schicht muss nicht das gesamte Siliziumsubstrat übergreifen, sondern kann lediglich in der Kavität und/oder der weiteren Kavität vorhanden sein. Dabei ist, wie bereits vorstehend erwähnt, eine Strukturierung möglich.

Eine Weiterbildung der Erfindung sieht vor, dass auf der metallischen Schicht eine, insbesonders elektrisch leitfähige, Verbindungsschicht vorgesehen ist. Auf der metallischen Schicht, welche auf der Passivierschicht aufgebracht ist, ist somit eine weitere Schicht, die Verbindungsschicht, aufgebracht. Ebenso wie die metallische Schicht muss sich diese nicht über das gesamte Siliziumsubstrat erstrecken, sondern kann beispielsweise lediglich in der Kavität und/oder der weiteren Kavität vorgesehen sein. Es ist auch möglich, dass lediglich ein Boden der weiteren Kavität die Verbindungsschicht aufweist. Die Verbindungsschicht ist vorzugsweise elektrisch leitfähig.

Eine Weiterbildung der Erfindung sieht vor, dass die Passivierschicht und/oder die metallische Schicht und/oder die Verbindungsschicht zwischen dem Substrat und dem Leuchtdioden-Chip vorgesehen ist. Das bedeutet, dass sich die Passivierschicht und/oder die metallische Schicht und/oder die Verbindungsschicht auf dem Boden der weiteren Kavität, über welchen der Leuchtdioden-Chip vorgesehen ist, befindet. Wenigstens eine dieser Schichten kann sich dabei über eine gesamte Bodenfläche des Leuchtdioden-Chips erstrecken, also an jeder zwischen Siliziumsubstrat und Leuchtdioden-Chip befindlichen Stelle vorhanden sein. Es kann jedoch auch vorgesehen sein, dass zumindest eine der Schichten lediglich an mindestens einer Stelle zwischen Siliziumsubstrat und Leuchtdioden-Chip vorhanden ist. Ebenso ist es möglich, dass sich zumindest eine der Schichten über die Bodenfläche des Leuchtdioden-Chips heraus erstreckt und auch auf den weiteren Bereichen des Siliziumsubstrats vorliegt.

Eine Weiterbildung der Erfindung sieht vor, dass auf einer dem Leuchtdioden-Chip abgewandten Seite des Substrats eine weitere metallische Schicht, insbesondere aus TiW oder Au bestehend oder dieses aufweisend, vorgesehen ist. Die Rückseite, also die dem Leuchtdioden-Chip abgewandte Seite des Substrats, weist die weitere metallische Schicht auf. Die weitere metallische Schicht kann strukturiert sein, also beispielsweise Leiterbahnen ausbilden. Es kann vorgesehen sein, dass sich die weitere Schicht über die gesamte Rückseite des Substrats erstreckt. Dies ist jedoch nicht notwendig.

Eine Weiterbildung der Erfindung sieht vor, dass eine Kante der Terrasse scharfkantig oder abgeflacht oder gerundet ausgebildet ist. Die von der weiteren Kavität in der Kavität ausgebildete Terrasse weist Kanten auf, die die Terrasse seitlich begrenzen. In Abhängigkeit von einem Herstellprozess kann diese Kante scharfkantig ausgebildet sein oder alternativ abgeflacht oder gerundet. Eine abgeflachte oder gerundete Kantenform der Kante reduziert die Gefahr von Kantenabrissen deutlich. Dies gilt insbesondere für Kantenabrisse bei Leiterbahnen im Bereich von Flanken der Kavität und/oder der weiteren Kavität.

Eine Weiterbildung der Erfindung sieht vor, dass die Kavität und/oder die weitere Kavität mittels KOH-Ätzen erzeugt ist. Für den bei der Herstellung der Kavität und/oder der weiteren Kavität durchgeführten Ätzprozess wird KOH als Ätzmittel verwendet. Seitenflanken der Kavität und/oder der weiteren Kavität sind somit (111) KOH-Ätzflanken.

Eine Weiterbildung der Erfindung sieht vor, dass eine Breite und/oder eine Länge der weiteren Kavität im Wesentlichen einer Breite und/oder einer Länge des Leuchtdioden-Chips entspricht. Die Abmessungen der weiteren Kavitäten werden auf die Abmessungen des Leuchtdioden-Chips abgestimmt. Auf diese Weise kann das unkontrollierte Wandern des Leuchtdioden-Chips beim Aufbauprozess verhindert werden, da dieser nun allseitig von Flanken der weiteren Kavität umgeben ist. Selbstverständlich kann auch vorgesehen sein, dass die Breite und/oder die Länge der weiteren Kavität so abgestimmt ist, dass mehrere Leuchtdioden-Chips in diese eingebracht werden können. In diesem Fall kann eine gleichzeitige Befestigung der Leuchtdioden-Chips in der weiteren Kavität erfolgen, wobei ebenfalls kein unkontrolliertes Wandern auftreten kann.

Eine Weiterbildung der Erfindung sieht vor, dass eine Kontaktierung das Leuchtdioden-Chips mittels Drahtbonden erfolgt. Eine elektrische Verbindung zu dem Leuchtdioden-Chip soll also über Bonddrähte, die mittels Drahtbonden angebracht sind, hergestellt sein. Dabei müssen nicht alle notwendigen Kontaktierungen der Leuchtdiode mittels Drahtbonden hergestellt werden. Es kann ebenso vorgesehen sein, dass lediglich eine Verbindung mittels Drahtbonden hergestellt ist und eine weitere über die Verbindungsschicht. Die mittels Drahtbonden aufgebrachten Bonddrähte verlaufen vorzugsweise so, dass sie entweder vollständig unterhalb der Oberkante der Kavität liegen oder keine direkte beziehungsweise unmittelbare Verbindung zu dem Leuchtdioden-Chip aufweisen.

Eine Weiterbildung der Erfindung sieht vor, dass eine Drahtbond-Verbindung zwischen dem Leuchtdioden-Chip und einer auf der Terrasse angeordneten Kontaktstelle und/oder zwischen der Kontaktstelle und einer außerhalb der Kavität angeordneten weiteren Kontaktstelle vorgesehen ist. Auf der Terrasse ist somit mindestens eine Kontaktstelle vorgesehen. Diese dient dazu, mittels eines kurzen Bonddrahtes eine Verbindung zu dem Leuchtdioden-Chip herzustellen. Ausgehend von der Kontaktstelle kann anschließend eine weitere Drahtbond-Verbindung von der Kontaktstelle ausgehend zu der weiteren Kontaktstelle, die außerhalb der Kavität angeordnet ist, vorliegen. Auf diese Weise ist es einfach möglich, den Bonddraht, welcher für die Drahtbond-Verbindung zwischen dem Leuchtdioden-Chip und der Kontaktstelle vorgesehen ist, vollständig unterhalb der Oberkante der Kavität anzuordnen. Somit kann gewährleistet werden, dass aus dem Leuchtdioden-Chip austretendes Licht aus dem Leuchtmodul gelangen kann, ohne dass es zu von dem Bonddraht verursachten Störungen kommt. Ebenso kann es vorgesehen sein, dass die Kontaktstelle eine elektrische Verbindung zu der metallischen Schicht und/oder der Verbindungsschicht aufweist und somit mittels eines Bonddrahts eine elektrische Verbindung von außerhalb der Kavität zu der metallischen Schicht und/oder der Verbindungsschicht hergestellt werden kann. Somit ist es also mittels der Drahtbond-Verbindung möglich, sowohl über die metallische Schicht beziehungsweise die Verbindungsschicht einen elektrischen Kontakt zu einer Unterseite des Leuchtdioden-Chips als auch zu einer Oberseite desselben herzustellen. Das bedeutet, dass die zwischen dem Leuchtdioden-Chip und der Kontaktstelle hergestellte Verbindung dazu eingesetzt wird, eine elektrische Verbindung zu einer Oberseite des Leuchtdioden-Chips herzustellen.

Eine Weiterbildung der Erfindung sieht vor, dass die Kavität und/oder die weitere Kavität mit einem Konvertierungsstoff, insbesondere Phosphor, zumindest teilweise ausgefüllt ist. Der Konvertierungsstoff kann lediglich in der weiteren Kavität, also den Leuchtdioden-Chip umgebend, vorgesehen sein. Es kann jedoch auch vorgesehen sein, dass die vollständige Kavität, einschließlich der weiteren Kavität, mit dem Konvertierungsstoff gefüllt ist. Dabei ist der Konvertierungsstoff in die Kavität mikrodosiert. Durch das Ausfüllen der Kavität sowie der weiteren Kavität mit dem Konvertierungsstoff wird sowohl der Leuchtdioden-Chip als auch die Drahtbond-Verbindungen vollständig mit diesem bedeckt und somit versiegelt. Durch die in der Kavität vorgesehene Füllung aus Konvertierungsstoff wird auch das seitlich aus den Leuchtdioden-Chips austretende Licht mitgenutzt, da der Konvertierungsstoff zwischen den Leuchtdioden-Chips zum Leuchten gebracht wird. Auf diese Weise werden dunkle Räume zwischen den Leuchtdioden-Chips minimiert. Ebenso werden durch den in der Kavität gleichmäßig vereilte Konvertierungsstoff Positionstoleranzen der Leuchtdioden-Chips ausgeglichen, da durch das Umschließen mit dem Konvertierungsstoff das Leuchtmodul ein eher diffuses Licht abgibt. Einzelne Leuchtdioden-Chips können somit nicht oder kaum ausgemacht werden.

Eine Weiterbildung der Erfindung sieht vor, dass der Konvertierungsstoff zumindest einen Bondraht einer Drahtbond-Verbindung zumindest bereichsweise umschließt. Der Bonddraht soll mit dem Konvertierungsstoff versiegelt werden. Dies geschieht vorteilhafterweise innerhalb der Kavität und/oder der weiteren Kavität. Zu diesem Zweck umschließt der Konvertierungsstoff den Bonddraht zumindest bereichsweise. Das bedeutet, dass der Bonddraht auch aus der Kavität herausragen kann, wobei lediglich der in der Kavität befindliche Teil von dem Konvertierungsstoff umfasst wird. Vorteilhaft ist dabei, wenn der Bonddraht vollständig von dem Konvertierungsstoff umschlossen wird, falls er sich unterhalb der Oberkante der Kavität befindet. Auf diese Weise werden unbeabsichtigte Kontaktierungen der Bonddrähte miteinander verhindert.

Eine Weiterbildung der Erfindung sieht vor, dass der Leuchtdioden-Chip in der weiteren Kavität mittels Löten und/oder Kleben befestigt ist. Der Leuchtdioden-Chip wird in die weitere Kavität eingebracht und dort befestigt. Das Befestigen kann auf verschiedenen Wegen geschehen, je nachdem ob eine elektrische Verbindung von einer Unterseite des Leuchtdioden-Chip zu der metallischen Schicht und/oder der Verbindungsschicht hergestellt werden soll. Soll die elektrische Verbindung hergestellt werden, so wird vorteilhafterweise Löten und/oder Kleben mit einem elektrisch leitfähigen Klebstoff verwendet.

Eine Weiterbildung der Erfindung sieht vor, dass das Substrat auf der dem Leuchtdioden-Chip abgewandten Seite mindestens eine Ausnehmung aufweist. Auf der Rückseite des Substrats, also der dem Leuchtdioden-Chip abgewandten Seite ist die mindestens eine Ausnehmung vorgesehen. Auf diese Weise können weitere Elemente nahe an den Leuchtdioden-Chip herangeführt werden. Vorstellbar sind beispielsweise eine Kühlvorrichtung und/oder eine elektrische Kontaktiervorrichtung. Mit Letzterer könnte der Leuchtdioden-Chip von der Rückseite des Substrats kontaktiert werden, womit eine Anzahl von Drahtbond-Verbindungen zumindest verringert werden könnte. Die Ausnehmung kann sich also durch das gesamte Substrat hinweg erstrecken. Es kann jedoch auch vorgesehen sein, dass lediglich eine Sackbohrung in dem Substrat vorgesehen ist.

Eine Weiterbildung der Erfindung sieht vor, dass die Ausnehmung auch die Passivierschicht durchgreift. Zunächst durchgreift die Ausnehmung also das Substrat vollständig und anschließend auch die Passivierschicht. Somit ist eine Ausnehmung vorhanden, welche bis zur der metallischen Schicht und/oder Verbindungsschicht und/oder dem Leuchtdioden-Chip reicht.

Eine Weiterbildung der Erfindung sieht vor, dass die Ausnehmung mit einem wärmeleitfähigen Material, insbesondere Cu, Ag und/oder Au aufweisend oder einem Lot zumindest teilweise ausgefüllt ist. Auf diese Weise kann die von dem Leuchtdioden-Chip erzeugte Wärme effizient abgeführt werden. Dabei wird die Ausnehmung mit dem wärmeleitfähigen Material zumindest bereichsweise ausgefüllt. Das bedeutet, dass eine wärmeleitfähige Verbindung zwischen dem Leuchtdioden-Chip, der Verbindungsschicht, der metallischen Schicht und/oder der Passivierschicht und der Rückseite des Substrats hergestellt ist, da das wärmeleitfähige Material Wärme besser leitet als das Substrat. Vorzugsweise sind an dieser Stelle Kupfer, Silber und/oder Gold verwendbar. Alternativ kann die Ausnehmung auch mit einem Lot zumindest teilweise ausgefüllt werden. Ist das wärmeleitfähige Material auch elektrisch leitfähig, so kann durch das Ausfüllen der Ausnehmung eine elektrische Verbindung von der Rückseite des Substrats zu dem Leuchtdioden-Chip hergestellt werden.

Eine Weiterbildung der Erfindung sieht vor, dass eine Wandung der Ausnehmung und/oder die dem Leuchtdioden-Chip abgewandte Seite des Substrats eine weitere Passivierschicht aufweist. Um das Substrat elektrisch von in die Ausnehmung eingebrachtem Material zu isolieren, wird auf die Wandung der Ausnehmung die weitere Passivierschicht aufgebracht. Diese kann auch auf der dem Leuchtdioden-Chip abgewandten Seite, also der Rückseite des Substrats vorgesehen sein. Vorzugsweise sind alle freien Oberflächen beziehungsweise alle Oberflächen des Substrats, welche mit elektrisch leitfähigem Material in Verbindung stehen, mit der weiteren Passivierschicht versehen.

Eine Weiterbildung der Erfindung sieht vor, dass eine weitere metallische Schicht auf der weiteren Passivierschicht vorgesehen ist. Die weitere Passivierschicht ist also mit der weiteren metallischen Schicht versehen. Diese ist vorzugsweise elektrisch leitfähig. Die weitere metallische Schicht kann strukturiert sein, also beispielsweise Leiterbahnen ausbilden. Die weitere metallische Schicht kann die weitere Passivierschicht vollständig übergreifen, es kann jedoch auch vorgesehen sein, dass die weitere metallische Schicht nur auf Bereichen der weiteren Passivierschicht angeordnet ist.

Eine Weiterbildung der Erfindung sieht vor, dass die weitere metallische Schicht die Ausnehmung und die Passivierschicht zur Kontaktierung des Leuchtdioden-Chips und/oder der Kontaktstelle durchgreift. Mittels der weiteren metallischen Schicht kann also eine elektrische Kontaktierung des Leuchtdioden-Chips und/oder der Kontaktstelle vorgenommen werden. Zu diesem Zweck durchgreift die Ausnehmung das Substrat und/oder die Passivierschicht und/oder die metallische Schicht und/oder die Verbindungsschicht, bis ein Kontakt zu dem Leuchtdioden-Chip und/oder der Kontaktstelle hergestellt werden kann. Eine Weiterbildung der Erfindung sieht vor, dass die weitere metallische Schicht mindestens eine Leiterbahn ausbildet. Die weitere metallische Schicht kann also strukturiert sein und auf der Rückseite des Substrats und/oder in der Ausnehmung mindestens eine Leiterbahn ausbilden. Auf diese Weise sind auf der Rückseite des Leuchtmoduls beziehungsweise in den Ausnehmungen komplexe elektrische Schaltungen realisierbar.

### Kurze Beschreibung der Zeichnungen

Die Erfindung wird anhand der in der Zeichnung dargestellten Ausführungsbeispiele näher erläutert, ohne dass eine Beschränkung der Erfindung erfolgt. Es zeigen:
- Figur 1: ein Leuchtmodul mit einem Substrat und einem Leuchtdioden-Chip, wobei das Substrat eine Kavität aufweist, in der eine weitere Kavität ausgebildet ist und der Leuchtdioden-Chip in der weiteren Kavität angeordnet ist,
- Figur 2: das aus Figur 1 bekannte Leuchtmodul, wobei das Substrat auf der dem Leuchtdioden-Chip abgewandten Seite Ausnehmungen aufweist, die das Substrat vollständig durchgreifen,
- Figur 3: das Leuchtmodul, wobei zwei Ausnehmungen vorgesehen sind, wobei sich eine der Ausnehmungen unterhalb des Leuchtdioden-Chips befindet und eine weitere Ausnehmung unterhalb einer Kontaktstelle auf einer durch die weitere Kavität in der Kavität ausgebildeten Terrasse,
- Figur 4: die aus Figur 3 bekannte Anordnung, wobei mehrere Ausnehmungen im Bereich des Leuchtdioden-Chips vorgesehen sind, und
- Figur 5: das aus Figur 4 bekannte Leuchtmodul, wobei die Ausnehmungen mit einem hoch wärmeleitfähigen Material gefüllt sind, um eine gute Wärmeabfuhr der von dem Leuchtdioden-Chip erzeugten Wärme zu erreichen.

### Ausführungsform(en) der Erfindung

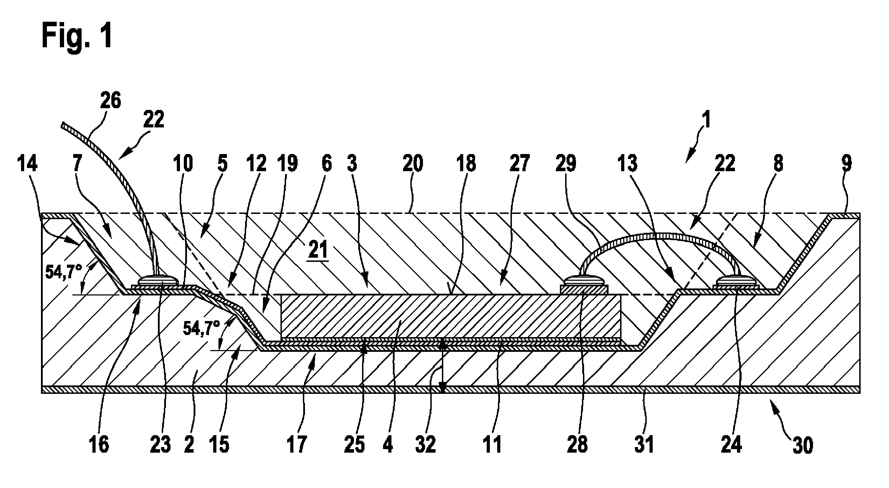

Die Figur 1 zeigt ein Leuchtmodul 1 mit einem Substrat 2, welches als Siliziumsubstrat ausgebildet ist, und einer Leuchtdiode 3, die als Leuchtdioden-Chip 4 ausgeführt ist. Das Leuchtmodul 1 kann auch mehrere Leuchtdioden-Chips 4 aufweisen. In dem Substrat 2 ist eine Kavität 5 vorgesehen, in der eine weitere Kavität 6 ausgebildet ist. Die weitere Kavität 6 ist so in der Kavität 5 angeordnet, dass - in der abgebildeten Schnittdarstellung - Terrassen 7 und 8 entstehen. Die Oberfläche des Substrats 2 ist mit einer Passivierschicht 9 versehen, die aus Siliziumoxid oder Siliziumdioxid besteht. Die Passivierschicht 9 ist auch innerhalb der Kavität 5 und der weiteren Kavität 6 vorgesehen, bedeckt also auch die Terrassen 7 und 8. Auf der Passivierschicht 9 ist bereichsweise eine metallische Schicht 10 vorgesehen. In dem dargestellten Beispiel verläuft die metallische Schicht 10 von der Terrasse 7 in die weitere Kavität 6 hinein und erstreckt sich bis unter den Leuchtdioden-Chip 4. Unmittelbar unter dem Leuchtdioden-Chip 4 ist eine Verbindungsschicht 11 angeordnet, diese ist also zwischen der metallischen Schicht 10 und dem Leuchtdioden-Chip 4 angeordnet. Die Verbindungsschicht 11 erstreckt sich lediglich in den Bereich, welcher von dem Leuchtdioden-Chip 4 in der weiteren Kavität 6 eingenommen wird. Die Verbindungsschicht 11 dient der elektrischen Verbindung des Leuchtdioden-Chips 4 mit der metallischen Schicht 10.

Die Terrasse 7 weist in Richtung der weiteren Kavität 6 Kanten 12 und 13 auf. Die Kanten 12 und 13 können scharfkantig, abgeflacht oder gerundet ausgebildet sein. Anhand der Kante 12 ist eine abgeflachte und anhand der Kante 13 eine scharfkantige Variante dargestellt. Die abgeflachte Kante 12 ist dann vorteilhaft, wenn auf der Passivierschicht die metallische Schicht 10 vorgesehen ist, da in diesem Fall nicht - wie bei der scharfkantigen Kante 13 - die Gefahr eines Ablösens der metallischen Schicht 10 besteht beziehungsweise vermindert ist. Eine Flanke 14 der Kavität 5 und eine Flanke 15 der weiteren Kavität 6 bilden jeweils mit einem Boden 16 der Kavität 5 beziehungsweise einem Boden 17 der weiteren Kavität 6 einen Winkel von 54,7° aus. Die weitere Kavität 6 weist eine derartige Tiefe auf, dass eine Oberfläche 18 des Leuchtdioden-Chips 4 unter oder auf einer Höhe der Oberkante 19 der weiteren Kavität 6 liegt. Die Kavität 5 und die weitere Kavität 6 sind bis zur einer Oberkante 20 der Kavität 5 mit einem Konvertierungsstoff 21 gefüllt. Beispielsweise kann der Konvertierungsstoff 21 Phosphor sein. Eine Breite und/oder eine Länge der weiteren Kavität 6 sind so gewählt, dass sie der Breite und/oder der Länge des Leuchtdioden-Chips 4 entsprechen. Der Leuchtdioden-Chip 4 wird also von den Flanken 15 der weiteren Kavität 6 eingefasst. Dies ist vorteilhaft während eines Aufbauprozesses des Leuchtmoduls 1, da auf die Weise der Leuchtdioden-Chip 4 problemlos verlötet werden kann, ohne in der weiteren Kavität 6 zu wandern. Eine elektrische Verbindung zu dem Leuchtdioden-Chip 4 ist über Drahtbond-Verbindungen 22 hergestellt. Zu diesem Zweck sind auf den Terrassen 7 und 8 Kontaktstellen 23 und 24 vorgesehen. Im Bereich der Kontaktstellen 23 und 24 sind beispielsweise keine Bereiche der metallischen Schicht 10 ausgebildet. Eine elektrische Verbindung zu einer Unterseite 25 des Leuchtdioden-Chips 4 wird mittels der metallischen Schicht 10 hergestellt, die sich von der Unterseite 25 bis zu der Kontaktstelle 23 auf der Terrasse 7 erstreckt. An der Kontaktstelle 23 ist mittels Drahtbonden ein Bondraht 26 befestigt, der aus dem Konvertierungsstoff 21 heraus verläuft. Somit ist eine Kontaktierung des Leuchtdioden-Chips von außerhalb des Leuchtmoduls 1 möglich. Eine Oberseite 27 wird kontaktiert, indem auf dieser eine Anschlussstelle 28 ausgebildet ist, die mittels eines Bonddrahts 29 mit der Kontaktstelle 24 auf der Terrasse 8 verbunden ist. Von dieser Kontaktstelle 24 kann, analog zu der Kontaktstelle 23, mittels eines Bonddrahts (nicht dargestellt) eine Verbindung aus dem Leuchtmodul 1 herausgeführt werden. Auf einer Rückseite 30 des Leuchtmoduls 1, welche dem Leuchtdioden-Chip 4 abgewandt ist, ist eine weitere metallische Schicht 31 vorgesehen. Da ein Abstand - dargestellt durch den Pfeil 32 - des Leuchtdioden-Chips 4 zu der Rückseite 30 im Bereich der weiteren Kavität 6 gering ist, kann die von dem Leuchtdioden-Chip 4 erzeugte Wärme sehr gut abgeführt werden. Diese Wärmeabführung wird durch die weitere metallische Schicht 31 verbessert, da diese sehr gut wärmeleitfähig ist. Zu diesem Zweck kann die weitere metallische Schicht 31 beispielsweise aus Kupfer, Silber oder Gold bestehen beziehungsweise diese Materialien aufweisen.

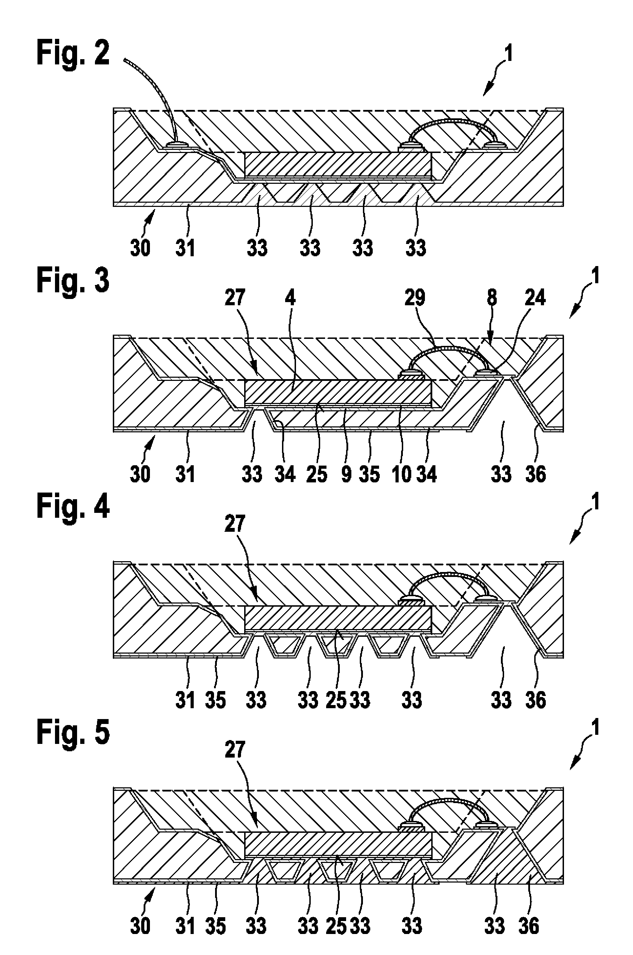

Die Figur 2 zeigt das aus der Figur 1 bekannte Leuchtmodul 1, wobei von der Rückseite 30 ausgehend Ausnehmungen 33 in das Substrat 2 eingebracht sind. Die Ausnehmungen 33 sind mit demselben Material gefüllt, aus welchem auch die weitere metallische Schicht 31 besteht. Die Ausnehmungen 33 werden beispielsweise mittels KOH-Ätzen erzeugt. Durch das Füllen der Ausnehmungen 33 mit demselben Material, aus dem auch die weitere metallische Schicht 31 besteht, also einem hoch wärmeleitfähigen Material, kann die von dem Leuchtdioden-Chip 4 erzeugte Wärme, der beispielsweise als Leistungs-LED ausgeführt sein kann, verbessert und dessen Lebensdauer erhöht werden.

In der Figur 3 ist eine weitere Variation des Leuchtmoduls 1 dargestellt. Bei dieser Variante sind von der Rückseite 30 her, im Bereich des Leuchtdioden-Chips 4 und der Kontaktstelle 24 die Ausnehmungen 33 vorgesehen. Dabei durchgreifen die Ausnehmungen 33 auch die Passivierschicht 9, so dass ein direkter Kontakt zu der metallischen Schicht 10 möglich ist. Auf der Rückseite 30 und in den Ausnehmungen 33 ist nun eine weitere Passivierschicht 34 vorgesehen. Die weitere metallische Schicht 31 erstreckt sich durch die Ausnehmungen 33 hindurch und stellt somit eine elektrische Verbindung zu der Unterseite 25 des Leuchtdioden-Chips 4 und der Kontaktstelle 24 auf der Terrasse 8 her. Zu diesem Zweck ist die weitere metallische Schicht 31 strukturiert, bildet also - in dem dargestellten Fall - zwei Leiterbahnen 35 und 36 aus, wobei die Leiterbahn 35 elektrisch mit der Rückseite 30 des Leuchtdioden-Chips 4 und die Leiterbahn 36 mit der Kontaktstelle 24 verbunden ist. Die Kontaktstelle 24 ist wiederum über den Bonddraht 29 mit der Oberseite 27 des Leuchtdioden-Chips 4 verbunden. Auf diese Weise ist es möglich, eine elektrische Verbindung zu dem Leuchtdioden-Chip 4 herzustellen, ohne aus dem Konvertierungsstoff 21 Bonddrähte 26 herauszuführen. Die Kontaktierung des Leuchtdioden-Chips 4 auf der Rückseite 30 kann beispielsweise mittels Flip-Chip-Technik erfolgen.

Die Figur 4 zeigt eine weitere Ausgestaltung des Leuchtmoduls 1. Analog zu dem in der Figur 3 dargestellten Beispiel erfolgt hier eine Kontaktierung der Unterseite 25 des Leuchtdioden-Chips 4 mittels einer Leiterbahn 35, welche durch Ausnehmungen 33 hindurch in elektrischer Verbindung mit der Unterseite 25 steht. Ebenso liegt eine elektrische Verbindung zu der Oberseite 27 über die Leiterbahn 36 vor. Im Unterschied zu dem in der Figur 3 dargestellten Beispiel sind nun mehrere Ausnehmungen 33 im Bereich des Leuchtdioden-Chips 4 vorgesehen. Ebenso erstreckt sich die Leiterbahn 35 in Form der weiteren metallischen Schicht 31 durch alle Ausnehmungen 33, welche unterhalb des Leuchtdioden-Chips 4 angeordnet sind. Auf diese Weise kann ein homogener Stromfluss durch den Leuchtdioden-Chip 4 sichergestellt und eine starke lokale Erwärmung vermieden werden.

Im Unterschied zu dem in Figur 4 dargestellten Beispiel zeigt die Figur 5 ein Leuchtmodul 1, bei welchem die Ausnehmungen 33 auf der Rückseite 30 des Leuchtmoduls 1 vollständig mit demselben Material ausgefüllt sind, aus welchem auch die weitere metallische Schicht 31 besteht. Somit kann neben dem Bereitstellen der elektrischen Verbindung zwischen der Leiterbahn 35 und der Unterseite 25 sowie der Leiterbahn 36 und der Oberseite 27 des Leuchtdioden-Chips 4 auch eine gute Wärmeleitung durch das Substrat 2 gewährleistet werden.

## Patentansprüche

1. Leuchtmodul (1) mit einem Substrat (2) und mindestens einer Leuchtdiode (3), wobei das Substrat (2) ein Siliziumsubstrat und die Leuchtdiode (3) ein Leuchtdioden-Chip (4) ist, **dadurch gekennzeichnet, dass** das Substrat (2) eine Kavität (5) aufweist, in der eine weitere Kavität (6) ausgebildet ist, und dass der Leuchtdioden-Chip (4) in der weiteren Kavität (6) angeordnet ist.

2. Leuchtmodul nach Anspruch 1, **dadurch gekennzeichnet, dass** die weitere Kavität (6) in der Kavität (5) mindestens eine Terrasse (7, 8) ausbildet.

3. Leuchtmodul nach einem der vorhergehenden Ansprüche, **dadurch gekennzeichnet, dass** auf dem Substrat (2) eine Passivierschicht (9), insbesondere aus SiO₂, aufgebracht ist.

4. Leuchtmodul nach einem der vorhergehenden Ansprüche, **dadurch gekennzeichnet, dass** auf der Passivierschicht (9) eine metallische Schicht (10), insbesondere aus TiW oder Au bestehend oder dieses aufweisend, vorgesehen ist.

5. Leuchtmodul nach einem der vorhergehenden Ansprüche, **dadurch gekennzeichnet, dass** auf der metallischen Schicht (10) eine, insbesondere elektrisch leitfähige, Verbindungsschicht (11) vorgesehen ist.

6. Leuchtmodul nach einem der vorhergehenden Ansprüche, **dadurch gekennzeichnet, dass** die Passivierschicht (9) und/oder die metallische Schicht (10) und/oder die Verbindungsschicht (11) zwischen dem Substrat (2) und dem Leuchtdioden-Chip (4) vorgesehen ist.

7. Leuchtmodul nach einem der vorhergehenden Ansprüche, **dadurch gekennzeichnet, dass** auf einer dem Leuchtdioden-Chip (4) abgewandten Seite (30) des Substrats (2) eine weitere metallische Schicht (31), insbesondere aus TiW oder Au bestehend oder dieses aufweisend, vorgesehen ist.

8. Leuchtmodul nach einem der vorhergehenden Ansprüche, **dadurch gekennzeichnet, dass** eine Kante (12, 13) der Terrasse (7, 8) scharfkantig oder abgeflacht oder gerundet ausgebildet ist.

9. Leuchtmodul nach einem der vorhergehenden Ansprüche, **dadurch gekennzeichnet, dass** die Kavität (5) und/oder die weitere Kavität (6) mittels KOH-Ätzen erzeugt ist.

10. Leuchtmodul nach einem der vorhergehenden Ansprüche, **dadurch gekennzeichnet, dass** eine Breite und/oder eine Länge der weiteren Kavität (6) im Wesentlichen einer Breite und/oder eine Länge des Leuchtdioden-Chips (4) anspricht.

11. Leuchtmodul nach einem der vorhergehenden Ansprüche, **dadurch gekennzeichnet, dass** eine Kontaktierung des Leuchtdioden-Chips (4) mittels Drahtbonden erfolgt.

12. Leuchtmodul nach einem der vorhergehenden Ansprüche, **dadurch gekennzeichnet, dass** eine Drahtbond-Verbindung (22) zwischen dem Leuchtdioden-Chip (4) und einer auf der Terrasse (7, 8) angeordneten Kontaktstelle (23, 24) und/oder zwischen der Kontaktstelle (23, 24) und einer außerhalb der Kavität (5) angeordneten weiteren Kontaktstelle vorgesehen ist.

13. Leuchtmodul nach einem der vorhergehenden Ansprüche, **dadurch gekennzeichnet, dass** die Kavität (5) und/oder die weitere Kavität mit einem Konvertierungsstoff (21), insbesondere Phosphor, zumindest teilweise ausgefüllt ist.

14. Leuchtmodul nach einem der vorhergehenden Ansprüche, **dadurch gekennzeichnet, dass** der Konvertierungsstoff (21) zumindest einen Bonddraht (26, 29) einer Drahtbond-Verbindung (22) zumindest bereichsweise umschließt.

15. Leuchtmodul nach einem der vorhergehenden Ansprüche, **dadurch gekennzeichnet, dass** der Leuchtdioden-Chip (4) in der weiteren Kavität (6) mittels Löten und/oder Kleben befestigt ist.

16. Leuchtmodul nach einem der vorhergehenden Ansprüche, **dadurch gekennzeichnet, dass** das Substrat (2) auf der dem Leuchtdioden-Chip (4) abgewandten Seite (30) mindestens eine Ausnehmung (33) aufweist.

17. Leuchtmodul nach einem der vorhergehenden Ansprüche, **dadurch gekennzeichnet, dass** die Ausnehmung (33) auch die Passivierschicht (9) durchgreift.

18. Leuchtmodul nach einem der vorhergehenden Ansprüche, **dadurch gekennzeichnet, dass** die Ausnehmung (33) mit einem wärmeleitfähigen Material, insbesondere Cu, Ag und/oder Au aufweisend, oder einem Lot zumindest teilweise ausgefüllt ist.

19. Leuchtmodul nach einem der vorhergehenden Ansprüche, **dadurch gekennzeichnet, dass** eine Wandung der Ausnehmung und/oder die dem Leuchtdioden-Chip (4) abgewandte Seite (30) des Substrats (2) eine weitere Passivierschicht (34) aufweist.

20. Leuchtmodul nach einem der vorhergehenden Ansprüche, **dadurch gekennzeichnet, dass** die weitere metallische Schicht (31) auf der weiteren Passivierschicht (34) vorgesehen ist.

21. Leuchtmodul nach einem der vorhergehenden Ansprüche, **dadurch gekennzeichnet, dass** die weitere metallische Schicht (31) die Ausnehmung (33) und die Passivierschicht (9) zur Kontaktierung des Leuchtdioden-Chips (4) und/oder der Kontaktstelle (23, 24) durchgreift.

22. Leuchtmodul nach einem der vorhergehenden Ansprüche, **dadurch gekennzeichnet, dass** die weitere metallische Schicht (31) mindestens eine Leiterbahn (35, 36) ausbildet.
